# FASCICULE DE BREVET EUROPEEN

(11) **EP 2 753 884 B1**
(45) Date de publication et mention de la délivrance du brevet: **28.10.2015**
(21) Numéro de dépôt: 12755861.7
(22) Date de dépôt: 05.09.2012
(51) Int. Cl.: F24J 2/06, F24J 2/40, F24J 2/24, F24J 2/50

(54) **DISPOSITIF THERMIQUE AVEC GUIDE DE LUMIERE**
THERMISCHE VORRICHTUNG MIT LICHTLEITER
THERMAL DEVICE WITH LIGHT GUIDE

(30) Priorité: 05.09.2011 FR 1157834
(43) Date de publication de la demande: 16.07.2014
(73) Titulaire: Commissariat à l'Énergie Atomique et aux Énergies Alternatives, 75015 Paris (FR)
(72) Inventeur: PILAT, Eric, F-73100 Brison-Saint-Innocent (FR); ALBARIC, Mickaël, F-73290 La Motte-Servolex (FR)
(74) Mandataire: Novaimo
(86) Numéro de dépôt international: PCT/EP2012/067265
(87) Numéro de publication internationale: WO 2013/034571

(56) Documents cités:
- WO-A1-2010/099620
- DE-A1- 19 709 653
- DE-A1-102004 032 357
- FR-A1- 2 913 101

## Description

L'invention concerne un dispositif solaire, comme un module thermique par exemple. Elle concerne aussi un procédé de fabrication d'un tel dispositif thermique.

Un module thermique a pour principe d'exploiter le rayonnement solaire pour produire de l'eau chaude, qui est exploitée par un système de chauffage d'un bâtiment et/ou pour la production de son eau chaude sanitaire. Le besoin en eau chaude fournie par un module thermique dépend fortement de la saison. En effet, le besoin est important en hiver, notamment pour le chauffage, et beaucoup moins important en été. Un inconvénient des dispositifs thermiques existants comprenant des modules thermiques provient du fait qu'ils accumulent trop d'énergie en été, ce qui induit une chaleur stockée inutilement qui entraîne notamment une surchauffe du dispositif, ce qui risque de le dégrader du fait de sa forte montée en température.

Ainsi, il existe un besoin d'une solution permettant de pallier à l'inconvénient mentionné ci-dessus.

A cet effet, l'invention repose sur un dispositif thermique comprenant une partie thermique comprenant une multitude de tubes caloporteurs pour le passage d'un fluide caloporteur, caractérisé en ce qu'il comprend un guide de lumière disposé au-dessus de la partie thermique, ce guide de lumière comprenant une propriété optique permettant de guider un rayon lumineux incident vers différentes directions en fonction de l'angle d'incidence du rayon lumineux incident, de sorte à orienter la majorité de la lumière incidente sur les tubes caloporteurs en incidence basse, comme en hiver, et à côté de ces tubes caloporteurs en incidence haute, comme en été.

L'invention est plus précisément définie par les revendications.

Ces objets, caractéristiques et avantages de la présente invention seront exposés en détail dans la description suivante de modes de réalisation particuliers faits à titre non-limitatif en relation avec les figures jointes parmi lesquelles :
La figure 1 représente schématiquement un module thermique selon un mode de réalisation de l'invention.
La figure 2 représente un grossissement d'une partie du guide de lumière du module thermique selon le mode de réalisation de l'invention.
La figure 3 représente schématiquement un guide de lumière selon une première variante de réalisation.
La figure 4 représente schématiquement un guide de lumière selon une seconde variante de réalisation.
La figure 5 représente schématiquement le fonctionnement du guide de lumière selon cette seconde variante de réalisation à partir d'un grossissement d'une partie du guide de lumière.
La figure 6 représente schématiquement l'implémentation sur un bâtiment d'un module thermique selon le mode de réalisation de l'invention.
Les figures 7 et 8 représentent des grossissements d'une partie du guide de lumière du module thermique selon le mode de réalisation de l'invention dans son implémentation de la figure 5.
La figure 9 représente l'évolution du coefficient de réflexion du guide de lumière selon un mode de réalisation de l'invention en fonction de l'angle incident d'un rayon lumineux.
La figure 10 représente schématiquement en perspective un composant denté du guide de lumière selon un mode de réalisation de l'invention.
La figure 11 représente schématiquement de côté le composant denté du guide de lumière selon le mode de réalisation de l'invention.
La figure 12 représente schématiquement le fonctionnement du guide de lumière selon un mode de réalisation de l'invention.
La figure 13 représente schématiquement le fonctionnement d'une variante du guide de lumière selon un mode de réalisation de l'invention.
La figure 14 représente schématiquement un module thermique hybride selon un mode de réalisation de l'invention.
La figure 15 représente schématiquement le fonctionnement du module thermique hybride selon le mode de réalisation de l'invention.
Les figures 16 à 18 représentent différentes étapes de procédés de fabrication d'un module thermique hybride selon un mode de réalisation de l'invention.

Dans la description suivante, les mêmes références seront utilisées pour des éléments similaires sur les différentes figures, pour une raison de simplification de la compréhension.

Les modes de réalisation de l'invention qui vont être décrits reposent sur l'utilisation d'un guide de lumière, qui permet de guider des rayons lumineux pour les diriger en sortie du guide de lumière de manière différente selon leur angle d'incidence, et notamment les orienter différemment lorsque l'angle d'incidence est bas, par exemple en hiver, et lorsque l'angle d'incidence est plus élevé, par exemple en été, en profitant de la hauteur différente du soleil selon les saisons. Ce guide de lumière fonctionne ainsi comme un switch automatique selon les saisons, permettant de faire basculer les rayons lumineux dans une zone ou une autre d'un dispositif solaire, tout en conservant un encombrement minimal du dispositif solaire.

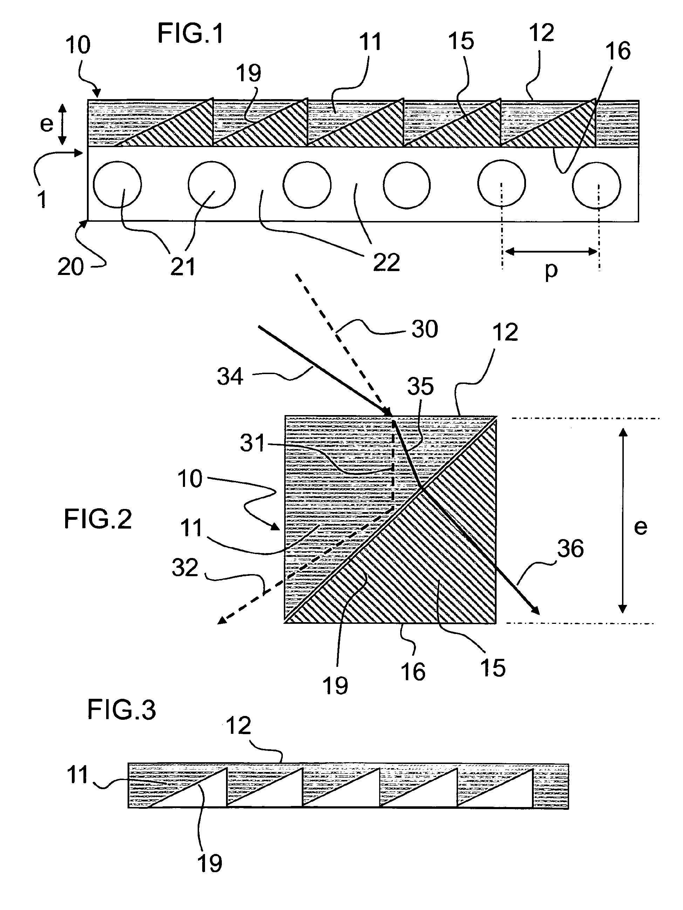

La figure 1 représente ainsi un module thermique 1 selon un mode de réalisation de l'invention. Ce module thermique comprend un guide de lumière 10 dans sa partie supérieure, formant un couvercle du module. Sous ce guide de lumière, il comprend une partie thermique 20 comprenant des tubes caloporteurs 21 parallèles répartis selon un pas p constant, inférieur ou égal à 50 mm, et séparés par des espaces 22.

Le guide de lumière 10 est formé de deux matériaux superposés aux propriétés optiques différentes. Un composant supérieur 11, comprenant le premier matériau, forme la surface supérieure 12 plane du guide de lumière, par laquelle arrivent les rayons lumineux incidents. Un composant inférieur 15, comprenant le second matériau, forme la surface inférieure 16 plane du guide de lumière, par laquelle sortent les rayons lumineux après leur traversée du guide de lumière 10, en direction de zones choisies de la partie thermique 20. Dans ce mode de réalisation, les deux matériaux sont rigides et transparents, translucides ou semi-transparents, par exemple des matériaux plastiques comme du PMMA, d'indices de réfraction différents. Ces deux matériaux comprennent de plus une surface interne au guide de lumière de forme dentée. Leurs formes dentées sont complémentaires de sorte à former une surface de liaison 19 interne continue entre les deux composants 11, 15 du guide de lumière, qui restent en contact sur toute cette surface de liaison 19. En remarque, la forme de chaque dent est composée d'une portion perpendiculaire aux surfaces supérieure 12 et inférieure 16 planes parallèles et d'une portion oblique. De plus, le pas de ces dents est le même pas p que celui des tubes caloporteurs 21 de la partie thermique 20 inférieure, pour obtenir un effet qui sera explicité par la suite.

La figure 2 illustre à titre d'exemple le parcours de deux rayons lumineux au sein du guide de lumière 10. Un premier rayon incident 30, présentant un angle d'incidence correspondant par exemple à une situation estivale, est réfracté en un rayon réfracté 31 au sein du premier composant 11 du guide de lumière à son arrivée sur la surface supérieure 12 du guide de lumière. Ce rayon réfracté 31 arrive ensuite sur la surface de liaison 19 oblique entre les deux composants 11, 15 du guide de lumière, selon un angle tel qu'il est réfléchi pour finalement générer en sortie du guide de lumière un rayon sortant 32 orienté dans une première direction. Un second rayon incident 34, présentant un faible angle d'incidence, correspondant par exemple à une situation hivernale, est réfracté en un rayon réfracté 35 au sein du premier composant 11 du guide de lumière à son arrivée sur la surface supérieure 12 du guide de lumière. Ce rayon réfracté 35 arrive ensuite sur la surface de liaison 19 entre les deux composants 11, 15 du guide de lumière, de sorte à générer un nouveau rayon réfracté 36 au sein du second composant puis en sortie inférieure du guide de lumière, dans une seconde direction. Ainsi, il apparaît bien que le guide de lumière 10 oriente différemment les rayons lumineux sortant de sa face inférieure 16 selon leur angle d'incidence, donc selon les saisons.

En remarque, un tel guide de lumière peut présenter des variantes. A cet effet, la figure 3 illustre une première variante d'un guide de lumière 10 dans lequel le second composant 15 est supprimé, remplacé par un espace rempli d'un gaz, comme de l'air ou de l'azote par exemple, qui remplit la fonction de second matériau aux propriétés optiques différentes, de manière équivalente au fonctionnement explicité en rapport avec la figure 2.

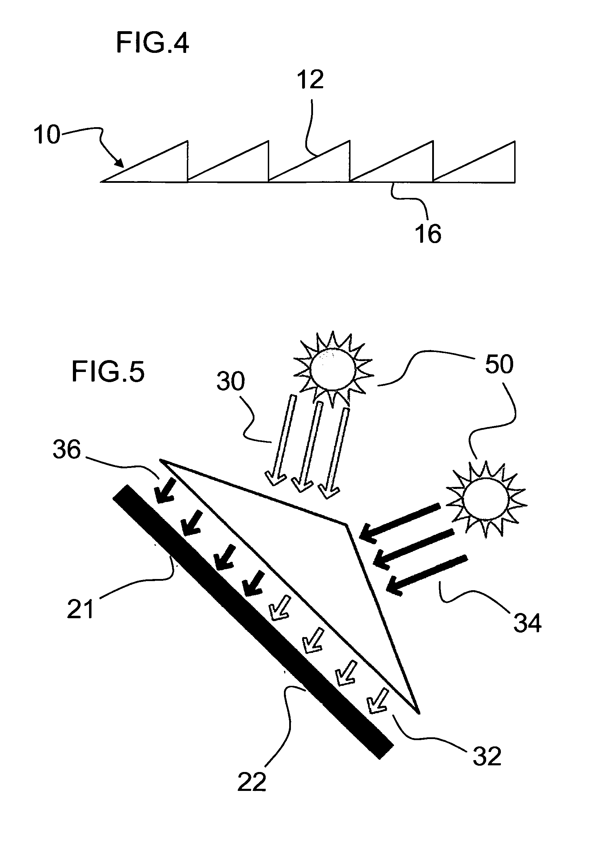

Les guides de lumière selon les réalisations décrites ci-dessus présentent l'avantage de présenter une surface supérieure 12 plane, ce qui facilite leur nettoyage par la pluie, évite l'accumulation de poussière ou autre. La figure 4 représente toutefois une seconde variante, dans laquelle le guide de lumière 20 ne comprend qu'un seul composant 11, et présente une surface supérieure 12 avec des reliefs, par exemple des dents, de sorte d'orienter les rayons lumineux différemment selon leur angle d'incidence.

La figure 5 illustre schématiquement le fonctionnement d'une telle variante sur une seule dent pour une raison de simplification, qui reçoit alternativement des rayons incidents 30 correspondant à une saison estivale et des rayons incidents 34 plus bas qui correspondent par exemple à la saison hivernale, selon la position du soleil 50. Ces rayons incidents 30, 34 d'angle d'incidence différent parviennent sur deux surfaces distinctes de la dent du guide de lumière 10, ce qui induit en sortie du guide de lumière 10 des rayons respectivement 32, 36 qui atteignent respectivement deux zones distinctes. Il sera naturellement choisi de faire correspondre la zone atteinte en hiver avec celle où se trouvent les tubes caloporteurs 21.

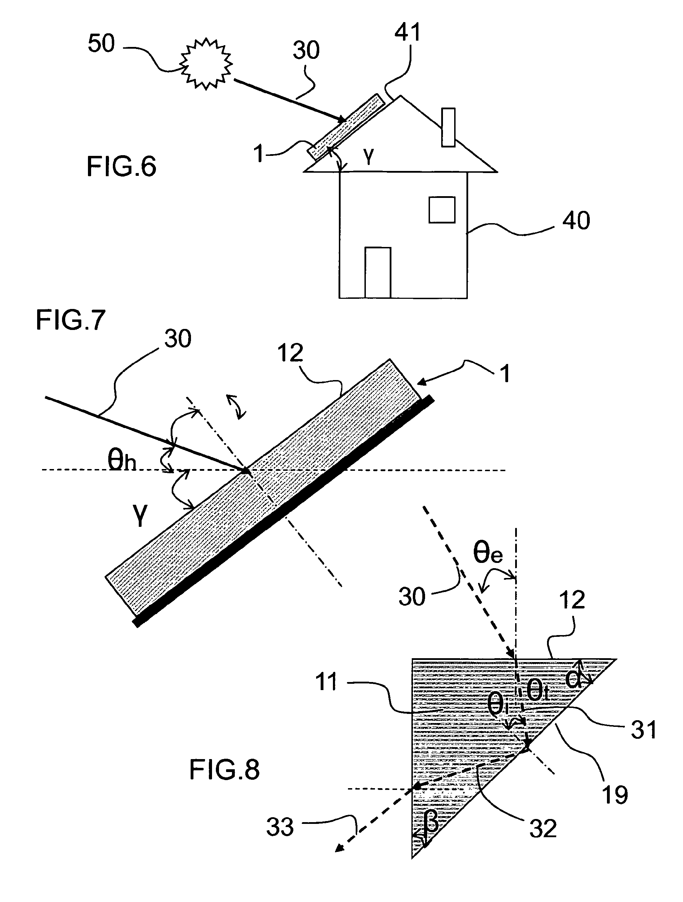

La figure 6 représente une implémentation d'un dispositif thermique tel que décrit ci-dessus en référence avec les figures 1 à 3 sur le toit 41 d'un bâtiment 40, pour fournir de l'eau chaude pour cette habitation. Le toit présente une pente γ par rapport à l'horizontal, ce qui définit l'angle d'inclinaison de la surface supérieure 12 du guide de lumière du dispositif thermique, qui reçoit un rayon lumineux 30 provenant du soleil 50, plus particulièrement représenté sur la figure 7, selon un angle d'incidence ϑₕ qui dépend de l'heure et de la saison, et de la latitude du bâtiment 40.

La figure 8 détaille le parcours du rayon lumineux 30 à l'intérieur du guide de lumière, qui atteint la surface supérieure 12 du guide de lumière avec un certain angle ϑₑ par rapport à sa normale. Il forme d'abord un rayon 31 réfracté qui atteint la surface de liaison 19 formant la surface inférieure du composant supérieur 11 du guide de lumière. Cette surface inférieure est inclinée d'un angle α par rapport à la surface supérieure 12 du guide de lumière. Ce rayon réfracté 31 atteint cette surface oblique avec un angle ϑᵢ par rapport à sa normale. Selon la valeur de cet angle ϑᵢ, le rayon 31 est soit réfracté au travers de cette surface, soit réfléchi en un rayon 32, comme représenté, pour finalement fournir en sortie du guide de lumière un rayon 33 présentant une certaine orientation, qui dépend donc de son angle d'incidence.

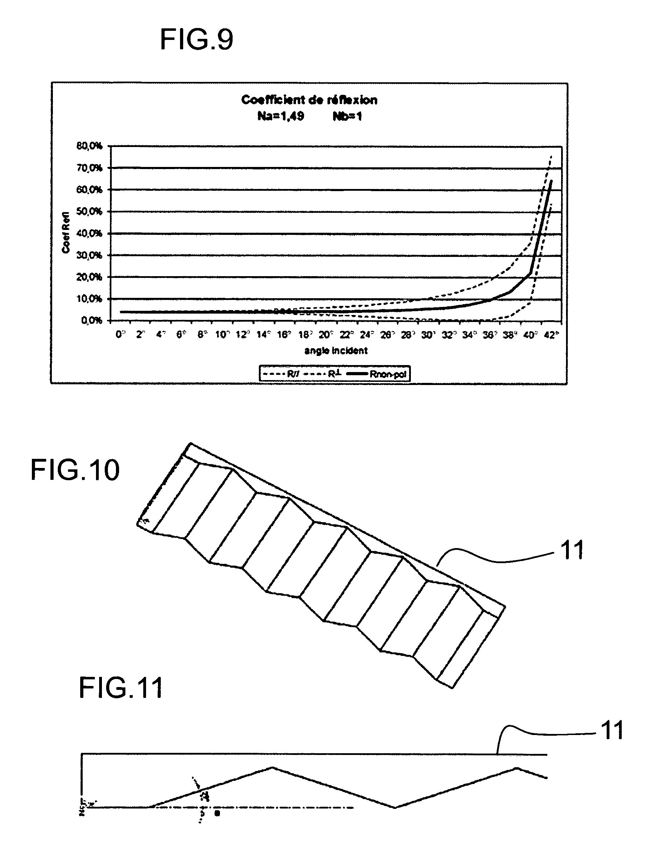

Comme cela apparaît sur la figure 9, le coefficient de réflexion du guide de lumière selon une variante représentée sur la figure 3 dépend de l'angle incident. Il apparaît dans l'exemple choisi pour lequel le premier matériau formant le premier composant 11 du guide de lumière présente un indice de réfraction de 1,49 alors que le second matériau présente un indice de réfraction de 1, qu'au-delà d'un angle d'incidence seuil de 42°, la totalité du rayon incident est réfléchi. Cela se traduit sur la figure 8 par une réflexion du rayon réfracté 31 si l'angle ϑᵢ est supérieur à 42°.

Les considérations précédentes montrent que l'homme du métier peut déterminer aisément la géométrie du guide de lumière à utiliser selon une implémentation particulière envisagée. En effet, il connaît d'abord l'angle d'incidence du rayonnement solaire en fonction des saisons, tenant notamment compte de la pente γ d'un toit 41 et de la latitude L du bâtiment 40 considéré (en hiver l'angle d'incidence ϑₕ d'un rayon lumineux par rapport à l'horizontale s'estime aisément en tenant compte que cette valeur au solstice d'hiver à midi se calcule par l'expression ϑₕ = 68 - L. De même, on sait qu'au solstice d'été à midi, cet angle devient ϑₕ = 112 - L). Ensuite, il n'a plus qu'à déterminer la géométrie du guide de lumière, notamment son épaisseur e, l'angle α d'inclinaison de la ou les surface(s) dentée(s), et du ou des indices de réfraction du ou des matériau(x) utilisé(s) pour obtenir un parcours souhaité d'un rayon lumineux en fonction de son angle d'incidence. Par exemple, le premier composant 11 de ce guide est représenté sur les figures 10 et 11 : il apparaît que sa géométrie peut être facilement définie et sa fabrication aisée, par moulage, rainuré par usinage, ou extrusion d'un matériau plastique comme du PMMA.

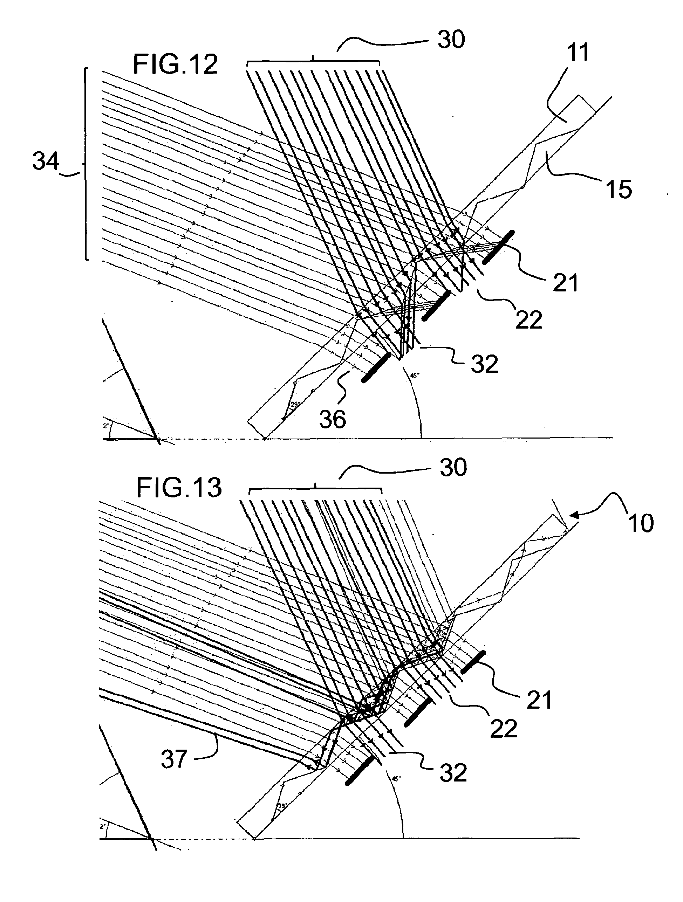

Ainsi, la figure 12 représente le comportement d'un dispositif thermique 1 tel que représenté sur la figure 1 avec les hypothèses suivantes :
- Latitude de 46° N (soit un angle d'incidence de 66° en été et 22° en hiver) ;
- Le premier composant 11 est du PMMA d'indice de réfraction de 1,491 (dans le vert), le guide de lumière se présente sous la forme d'une plaque de 6 mm d'épaisseur (e=6 mm), avec des dents inclinées d'un angle α de 29° ;
- Le second composant 15 est de l'air d'indice de réfraction de 1 ;
- Le module thermique 1 est disposé selon une inclinaison de 45°.
Comme cela est visible sur cette figure 12, les rayons lumineux 30 en été sont guidés en sortie de sorte à former des rayons transmis 32 orientés dans les zones 22 intercalées entre les différents tubes caloporteurs 21, ce qui permet à ces derniers de recevoir un minimum de chaleur et d'éviter le problème de surchauffe rencontré dans l'état de la technique. Inversement, les rayons lumineux 34 en hiver sont guidés en sortie en des rayons lumineux 36 dirigés spécifiquement sur les tubes caloporteurs 21, pour leur transmettre un maximum de chaleur au moment du plus fort besoin.

Naturellement, les deux rayons lumineux incidents représentent les situations extrêmes, aux solstices d'été et d'hiver à midi, et il existe toutes sortes de configurations intermédiaires en fonction des saisons et de l'heure, durant lesquelles les rayons sortants du guide de lumière sont répartis partiellement sur les tubes caloporteurs 21 et partiellement en dehors. Il en ressort quand même qu'avec la configuration choisie, les tubes caloporteurs 21 reçoivent globalement beaucoup plus les rayons lumineux l'hiver que l'été, ce qui correspond bien à l'effet recherché. En remarque, le pas p des dents des composants 11, 15 du guide de lumière correspond au pas de répartition des tubes caloporteurs 21 pour obtenir cette correspondance des rayons en sortie. Toutefois, d'autres géométries sont envisageables, comme des pas non constants, et/ou des dents de géométrie variable, remplacées par de simples reliefs, rainures, etc. En remarque, on note que le guide de lumière ainsi décrit ne se comporte pas comme un amplificateur du rayonnement, n'a par exemple pas d'effet de concentration des rayons sur certaines zones. Il se contente de modifier l'orientation des rayons, pour les basculer d'une zone vers une autre selon les saisons. Dans l'implémentation choisie, on distingue donc une première zone formée des tubes caloporteurs 21, qui est privilégiée en hiver, et une seconde zone formée par les espacements 22 entre les tubes caloporteurs, qui est privilégiée en été. Ces deux zones sont composées d'une multitude de bandes parallèles intercalées.

L'implémentation précédente d'un dispositif thermique pourra aussi être différente. Toutefois, ce dispositif thermique se présentera avantageusement sous la forme d'un ou plusieurs modules appelés panneau(x) présentant une inclinaison de 20 à 60° par rapport à l'horizontale, voire 30 à 45°. De plus, chaque module thermique comprendra avantageusement un guide de lumière avec un matériau d'indice de réfraction compris entre 1,2 et 1,8, voire entre 1,4 et 1,7 inclus. Un module thermique présentera une épaisseur avantageusement inférieure à 10 mm, voire inférieure ou égale à 6 mm, ce qui représente environ 10% de l'épaisseur du dispositif complet.

La figure 13 représente le comportement d'un dispositif thermique légèrement modifié en remplaçant le premier matériau par un matériau d'indice de réfraction de 1,6 (dans le vert). On note que ce dispositif se comporte différemment par le fait qu'une partie des rayons incidents est réfléchie par le guide de lumière 10. On voit par exemple des rayons réfléchis 37 provenant des rayons incidents 30 en été. Une telle variante de réalisation présente un intérêt dans une utilisation sur une paroi vitrée d'un bâtiment par exemple, pour réduire en été la quantité de lumière et donc de chaleur entrant dans le bâtiment.

L'invention décrite précédemment permet la mise en oeuvre avantageuse de dispositifs solaires hybrides.

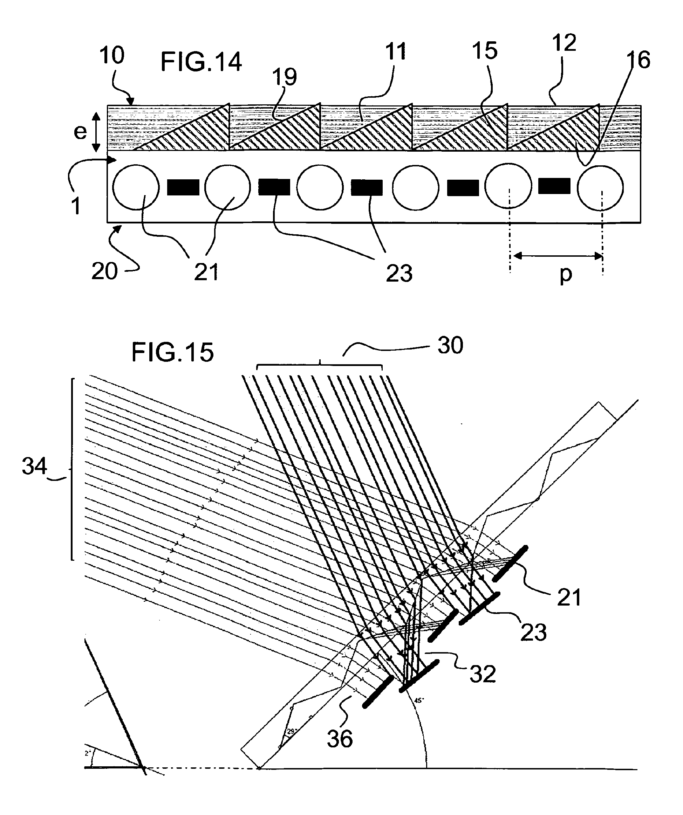

A cet effet, la figure 14 représente un module thermique hybride, qui comprend les éléments déjà décrits en rapport avec la figure 1, et qui comprend de plus des cellules photovoltaïques 23 disposées entre les tubes caloporteurs 21. Ainsi, ce dispositif permet de profiter de la présence d'un rayonnement solaire non exploité en été pour produire de l'électricité. La figure 15 représente le fonctionnement d'un tel module hybride, en reprenant les mêmes hypothèses que celles liées à la figure 12. En été, les rayons lumineux sortants 32 sont guidés sur les cellules photovoltaïques 23 alors qu'en hiver, ils sont dirigés sur les tubes caloporteurs 21.

Selon un mode de réalisation avantageux, le module thermique présente une très faible épaisseur, pour faciliter son intégration. Cette épaisseur dépend d'abord des dimensions du guide de lumière, qui doit donc présenter une épaisseur e la plus petite possible. Or, pour remplir sa fonction optique décrite ci-dessus, la base L de ses éléments de type prisme, qui correspond aux pas p des cellules photovoltaïques 23 et des tubes caloporteurs 21, est sensiblement égale à son épaisseur e. Ainsi, le choix d'une épaisseur e très faible nécessite un pas p très faible, sensiblement égal à e.

Le diamètre standard d'un tube caloporteur est de 14 mm et la largeur habituelle des cellules photovoltaïques est de l'ordre de 156 mm. Nous allons décrire un procédé de fabrication d'un module thermique hybride qui permet d'obtenir une épaisseur très faible, significativement plus faible que si des éléments à ces dimensions standard étaient utilisés.

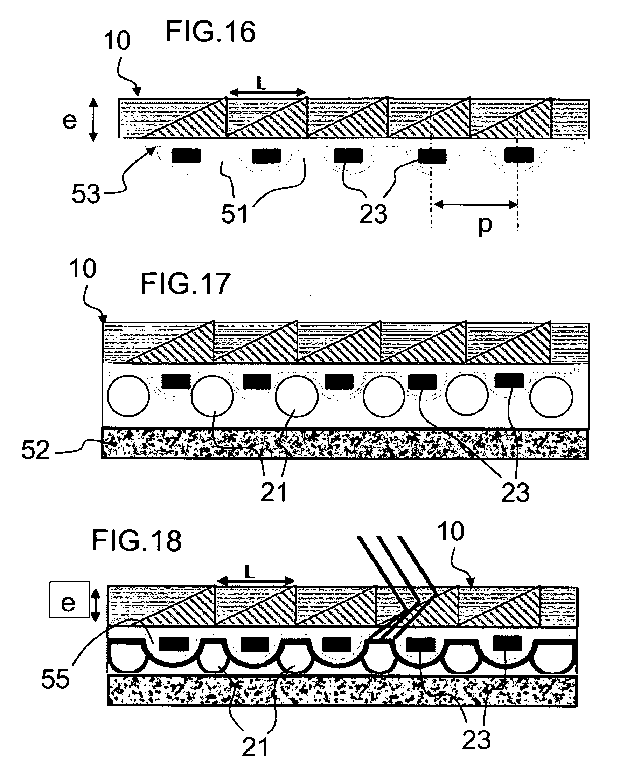

Selon un premier mode de réalisation, le procédé de fabrication d'un module thermique commence par fabriquer les cellules photovoltaïques adaptées au module hybride. Ce procédé comprend les étapes suivantes :
- En première étape, des cellules photovoltaïques 23 sont découpées en bandes adaptées à la largeur souhaitée, c'est-à-dire de l'ordre de 10 mm selon un exemple choisi. Cette découpe est par exemple réalisée avec un laser ou un système de découpe à base de scie diamantée ;
- En seconde étape, les cellules photovoltaïques 23 sont découpées et reliées entre elles, par exemple par soudure, pour former une guirlande de longueur égale à celle du module thermique ;
- En troisième étape, le guide de lumière 10 et les cellules photovoltaïques 23 sont laminées, à base d'une résine de liant 53 comme de l'EVA ou du silicone. Cette étape comprend aussi la création d'emplacements 51 dédiés aux tubes caloporteurs 21 pour la fonction thermique du module thermique. Le résultat obtenu par cette étape est illustré par la figure 16 ;
- En quatrième étape, la partie thermique est ajoutée au module thermique précédemment formé. Cette partie thermique comprend les tubes caloporteurs 21, qui peuvent se présenter sous la forme d'un réseau tubulaire, arrangé sous forme de peigne ou de serpentin. Cette partie thermique peut en variante être obtenue par soufflage sous haute pression (type Roll Bond), ce mode de réalisation permettant d'ajuster la surface d'échange en fonction du système optique. Eventuellement, un laminé polymère (comme du TPT par exemple) est ajouté pour former une face arrière 52. Le résultat obtenu par cette étape est illustré par la figure 17.

Selon un second mode de réalisation, la partie thermique peut être d'abord réalisée, selon une étape de soufflage sous haute pression. Cette partie thermique forme des emplacements 55 pour le positionnement des cellules photovoltaïques 23. Enfin, une étape suivante consiste en l'ajout du guide de lumière 10 en partie supérieure du module thermique, qui peut être monté par tout assemblage mécanique ou collage, à partir d'une colle formant une liaison entre le guide de lumière et les cellules photovoltaïques.

Ce procédé permet d'obtenir des modules thermiques avec des tubes caloporteurs de diamètre inférieur ou égal à 12 mm, voire inférieur ou égal à 10 mm, par exemple de l'ordre de 8 mm, et/ou avec des cellules photovoltaïques de largeur inférieure ou égale à 12 mm, par exemple de l'ordre de 10 mm.

Ce principe peut être exploité pour former d'autres dispositifs solaires hybrides, comme par exemple pour un dispositif combinant un rideau ou store semi-transparent pour la lumière, formant une obstruction ou non pour la lumière, et une production d'électricité photovoltaïques. En effet, il peut être choisi de laisser traverser un maximum de rayons lumineux au travers du dispositif en hiver, pour obtenir un éclairage maximal d'un bâtiment, formant ainsi une fonction de puits de lumière par exemple, et d'empêcher ou limiter la pénétration des rayons de lumière dans le bâtiment l'été, pour leur éviter de chauffer le bâtiment, et en les orientant alors sur des cellules photovoltaïques. Dans une telle variante, le dispositif solaire présente une architecture proche de celle de la figure 14, en remplaçant les tubes caloporteurs 21 par espaces transparents. Dans une telle implémentation, le guide de lumière permet ainsi de former un dispositif semi-transparent, dont la transparence évolue en fonction de l'orientation des rayons de lumière incidents, et donc en fonction du temps, et notamment des saisons.

En remarque, les étapes des procédés de fabrication décrits ci-dessus permettent avantageusement d'obtenir un module thermique hybride. Il est naturellement possible de reprendre partiellement ces étapes pour fabriquer un module thermique simple, tel que celui par exemple présenté sur les figures 1 à 3.

## Revendications

1. Dispositif thermique comprenant une partie thermique (20) comprenant une multitude de tubes caloporteurs (21) pour le passage d'un fluide caloporteur, **caractérisé en ce qu'**il comprend un guide de lumière (10) disposé au-dessus de la partie thermique (20), ce guide de lumière (10) comprenant une propriété optique permettant de guider un rayon lumineux incident vers différentes directions en sortie en fonction de l'angle d'incidence du rayon lumineux incident, de sorte à orienter la majorité de la lumière incidente sur les tubes caloporteurs (21) en incidence basse, comme en hiver, et à côté de ces tubes caloporteurs (21) en incidence haute, comme en été.

2. Dispositif thermique selon la revendication précédente, **caractérisé en ce que** le guide de lumière (10) comprend au moins un composant (11 ; 15) comprenant une surface dentée.

3. Dispositif thermique selon l'une des revendications précédentes, **caractérisé en ce que** le guide de lumière (10) comprend une surface supérieure (12) plane destinée à recevoir la lumière incidente.

4. Dispositif thermique selon l'une des revendications précédentes, **caractérisé en ce que** le guide de lumière comprend deux composants (11, 15) comprenant deux matériaux aux propriétés optiques différentes, notamment d'indices de réfraction différents.

5. Dispositif thermique selon la revendication précédente, **caractérisé en ce que** les deux composants (11, 15) du guide de lumière comprennent chacun des surfaces dentées complémentaires emboîtées l'une dans l'autre au niveau d'une surface de liaison (19).

6. Dispositif thermique selon l'une des revendications précédentes, **caractérisé en ce que** les tubes caloporteurs (21) sont sensiblement parallèles et espacés d'un pas (p) constant, et **en ce que** le guide de lumière (10) comprend une surface dentée de même pas.

7. Dispositif thermique selon l'une des revendications précédentes, **caractérisé en ce que** le guide de lumière comprend au moins un composant en matériau plastique, comme du PMMA, et/ou **en ce qu'**il comprend au moins un matériau d'indice de réfraction compris entre 1,2 et 1,8, et/ou **en ce qu'**il comprend une épaisseur (e) entre 5 et 10 mm.

8. Dispositif thermique selon l'une des revendications précédentes, **caractérisé en ce qu'**il comprend des cellules photovoltaïques (23) intercalées entre les tubes caloporteurs (21), de sorte que la lumière est majoritairement orientée sur les tubes caloporteurs (21) en incidence basse et sur les cellules photovoltaïques (23) en incidence haute.

9. Dispositif thermique selon la revendication précédente, **caractérisé en ce que** les tubes caloporteurs (21) présentent un diamètre inférieur ou égal à 12 mm, ou inférieur ou égal à 10 mm, et/ou **en ce que** les cellules photovoltaïques (23) présentent une largeur inférieure ou égale à 12 mm.

10. Procédé de fabrication d'un dispositif thermique selon l'une des revendications 1 à 9, **caractérisé en ce qu'**il comprend une étape de fabrication d'une partie thermique qui comprend des tubes caloporteurs (21), du type se présentant sous la forme d'un réseau tubulaire, arrangé sous forme de peigne ou de serpentin, ou de réalisation de cette partie thermique par une étape de soufflage sous haute pression, puis une étape de fixation d'un guide de lumière (10) en partie supérieure de la partie thermique.

11. Procédé de fabrication d'un dispositif thermique selon la revendication précédente, **caractérisé en ce que** le dispositif thermique est hybride et **en ce qu'**il comprend les étapes suivantes :
- découpe de cellules photovoltaïques (23) en bandes ;
- liaison des cellules photovoltaïques (23) entre elles pour former une guirlande de longueur égale à celle du module thermique ;
- création d'emplacements (51) pour recevoir des tubes caloporteurs (21) d'une partie thermique ou création d'emplacements (55) sur la partie thermique pour recevoir les cellules photovoltaïques (23).

## Patentansprüche

1. Thermische Vorrichtung, umfassend ein thermisches Teil (20), umfassend eine Vielzahl von Wärmerohren (21) für den Durchgang eines Wärmefluids, **dadurch gekennzeichnet, dass** sie einen Lichtleiter (10) umfasst, der über dem thermischen Teil (20) angeordnet ist, wobei dieser Lichtleiter (10) eine optische Eigenschaft umfasst, die es ermöglicht, einen einfallenden Lichtstrahl in verschiedene Richtungen am Ausgang in Abhängigkeit vom Einfallswinkel des einfallenden Lichtstrahls zu führen, um die Mehrheit des einfallenden Lichts auf Wärmerohre (21) bei einem flachen Einfallswinkel, wie im Winter, und neben diese Wärmerohre (21) bei einem steilen Einfallswinkel, wie im Sommer zu lenken.

2. Thermische Vorrichtung nach dem vorhergehenden Anspruch, **dadurch gekennzeichnet, dass** der Lichtleiter (10) mindestens eine Komponente (11; 15) umfasst, die eine gezahnte Fläche aufweist.

3. Thermische Vorrichtung nach einem der vorhergehenden Ansprüche, **dadurch gekennzeichnet, dass** der Lichtleiter (10) eine obere ebene Fläche (12) umfasst, die dazu bestimmt ist, das einfallende Licht aufzunehmen.

4. Thermische Vorrichtung nach einem der vorhergehenden Ansprüche, **dadurch gekennzeichnet, dass** der Lichtleiter zwei Komponenten (11, 15) umfasst, die zwei Materialien mit unterschiedlichen optischen Eigenschaften, insbesondere unterschiedlichen Brechungsindizes, umfassen.

5. Thermische Vorrichtung nach dem vorhergehenden Anspruch, **dadurch gekennzeichnet, dass** die beiden Komponenten (11, 15) des Lichtleiters jeweils komplementäre gezahnte Flächen umfassen, die auf Höhe einer Verbindungsfläche (19) ineinander gesteckt sind.

6. Thermische Vorrichtung nach einem der vorhergehenden Ansprüche, **dadurch gekennzeichnet, dass** die Wärmerohre (21) im Wesentlichen parallel und um einen konstanten Abstand (p) beabstandet sind, und dass der Lichtleiter (10) eine gezahnte Fläche mit demselben Abstand umfasst.

7. Thermische Vorrichtung nach einem der vorhergehenden Ansprüche, **dadurch gekennzeichnet, dass** der Lichtleiter mindestens eine Komponente aus Kunststoff, wie PMMA, umfasst, und/oder dass er mindestens ein Material mit einem Brechungsindex zwischen 1,2 und 1,8 umfasst, und/oder dass er eine Dicke (e) zwischen 5 und 10 mm umfasst.

8. Thermische Vorrichtung nach einem der vorhergehenden Ansprüche, **dadurch gekennzeichnet, dass** sie Photovoltaikzellen (23) umfasst, die zwischen den Wärmerohren (21) angeordnet sind, so dass das Licht mehrheitlich auf die Wärmerohre (21) bei einem flachen Einfallswinkel und auf die Photovoltaikzellen (23) bei einem steilen Einfallswinkel gelenkt wird.

9. Thermische Vorrichtung nach dem vorhergehenden Anspruch, **dadurch gekennzeichnet, dass** die Wärmerohre (21) einen Durchmesser kleiner oder gleich 12 mm oder kleiner oder gleich 10 mm aufweisen, und/oder dass die Photovoltaikzellen (23) eine Breite kleiner oder gleich 12 mm aufweisen.

10. Verfahren zur Herstellung einer thermischen Vorrichtung nach einem der Ansprüche 1 bis 9, **dadurch gekennzeichnet, dass** es einen Schritt der Herstellung eines thermischen Teils, das Wärmerohre (21) umfasst, die in Form eines Rohrnetzes vorhanden, in Form eines Kamms oder einer Schlange angeordnet sind, oder der Herstellung dieses thermischen Teils durch einen Schritt des Blasformens unter hohem Druck und dann einen Schritt der Befestigung eines Lichtleiters (10) im oberen Teil des thermischen Teils umfasst.

11. Verfahren zur Herstellung einer thermischen Vorrichtung nach dem vorhergehenden Anspruch, **dadurch gekennzeichnet, dass** die thermische Vorrichtung hybrid ist, und dass es die folgenden Schritte umfasst:
- Schneiden von Photovoltaikzellen (23) zu Streifen;
- Verbinden der Photovoltaikzellen (23) miteinander, um eine Girlande mit einer Länge gleich jener des thermischen Moduls zu bilden;
- Schaffen von Standorten (51) für die Aufnahme von Wärmerohren (21) eines thermischen Teils oder Schaffen von Standorten (55) auf dem thermischen Teil, um die Photovoltaikzellen (23) aufzunehmen.

## Claims

1. Thermal device comprising a thermal part (20) comprising a multitude of heat-transfer tubes (21) for the passage of a heat-transfer fluid, **characterized in that** it comprises a light guide (10) placed above the thermal part (20), this light guide (10) having an optical property allowing an incident light ray to be guided in various exit directions depending on the angle of incidence of the incident light ray, so as to orient most of the incident light onto the heat-transfer tubes (21) at low incidence, such as in winter, and to beside these heat-transfer tubes (21) at high incidence, such as in summer.

2. Thermal device according to the preceding claim, **characterized in that** the light guide (10) comprises at least one component (11; 15) comprising a toothed surface.

3. Thermal device according to one of the preceding claims, **characterized in that** the light guide (10) comprises a flat upper surface (12) intended to receive the incident light.

4. Thermal device according to one of the preceding claims, **characterized in that** the light guide comprises two components (11, 15) comprising two materials with different optical properties, especially different refractive indices.

5. Thermal device according to the preceding claim, **characterized in that** the two components (11, 15) of the light guide each comprise complementary toothed surfaces that interfit with each other at a joining surface (19).

6. Thermal device according to one of the preceding claims, **characterized in that** the heat-transfer tubes (21) lie substantially parallel and are spaced apart at a constant pitch (p), and **in that** the light guide (10) comprises a toothed surface of the same pitch.

7. Thermal device according to one of the preceding claims, **characterized in that** the light guide comprises at least one component made of a plastic, such as PMMA, and/or **in that** it comprises at least one material having a refractive index comprised between 1.2 and 1.8, and/or **in that** its thickness (e) is between 5 and 10 mm.

8. Thermal device according to one of the preceding claims, **characterized in that** it comprises photovoltaic cells (23) inserted between the heat-transfer tubes (21), so that the light is mainly oriented onto the heat-transfer tubes (21) at low incidence and onto the photovoltaic cells (23) at high incidence.

9. Thermal device according to the preceding claim, **characterized in that** the heat-transfer tubes (21) are smaller than or equal to 12 mm in diameter, or smaller than or equal to 10 mm in diameter, and/or **in that** the photovoltaic cells (23) are smaller than or equal to 12 mm in width.

10. Process for manufacturing a thermal device according to one of claims 1 to 9, **characterized in that** it comprises a step of manufacturing a thermal part that comprises heat-transfer tubes (21), of the type taking the form of a tubular network arranged in a comb or serpentine, or of producing this thermal part in a high-pressure blow moulding step, then a step of fixing a light guide (10) on top of the thermal part.

11. Process for manufacturing a thermal device according to the preceding claim, **characterized in that** the thermal device is a hybrid device, and **in that** it comprises the following steps:
- cutting photovoltaic cells (23) into strips;
- connecting photovoltaic cells (23) together in order to form a string of length equal to that of the thermal module; and
- creating locations (51) for receiving heat-transfer tubes (21) of a thermal part, or creating locations (55) on the thermal part for receiving the photovoltaic cells (23).
